# EUROPEAN PATENT APPLICATION

(11) **EP 4 047 638 A1**
(43) Date of publication of application: **24.08.2022**
(21) Application number: 20876453.0
(22) Date of filing: 16.06.2020
(51) Int. Cl.: H01L 21/52

(54) **SEMICONDUCTOR PACKAGING METHOD, SEMICONDUCTOR PACKAGING STRUCTURE, AND PACKAGES**

(30) Priority: 16.10.2019 CN 201910982067
(71) Applicant: Changxin Memory Technologies, Inc., Anhui 230000 (CN)
(72) Inventor: LIU, Jie, Hefei, Anhui 230000 (CN); YING, Zhan, Hefei, Anhui 230000 (CN)
(74) Representative: Lavoix
(86) International application number: PCT/CN2020/096258
(87) International publication number: WO 2021/073135

(57) **Abstract**

This invention provides a method for packaging a semiconductor, a semiconductor package structure, and a package. The packaging method includes the following steps: providing a substrate wafer having a first surface and a second surface arranged opposite to each other, the first surface having a plurality of grooves, a plurality of electrically conductive pillars being provided at a bottom of the groove, and the electrically conductive pillar penetrating through the bottom of the groove to the second surface; providing a plurality of semiconductor die stacks; placing the semiconductor die stack in the groove, an upper surface of the semiconductor die stack being lower than or flush with an upper edge of the groove, and a bottom of the semiconductor die stack being electrically connected to the electrically conductive pillar; and covering an insulating material on the upper surface of the semiconductor die stack to form an insulating dielectric layer, the insulating dielectric layer being filled in upper parts of gaps among sidewalls of the plurality of grooves and the plurality of semiconductor die stacks to seal up the plurality of semiconductor die stacks, to thus forma semiconductor package structure. The advantage of the present invention rests in the fact that the semiconductor package structure as formed is characterized by lower package height, higher stability, higher reliability, and lower warpage.

## Description

### CROSS-REFERENCE TO RELATED APPLICATION

This application claims priority to Chinese Patent Application No. 201910982067.2, entitled "METHOD FOR PACKAGING SEMICONDUCTOR, SEMICONDUCTOR PACKAGE STRUCTURE, AND PACKAGE" and filed on October 16, 2019, the entire contents of which are incorporated herein by reference.

### FIELD OF THE INVENTION

The present disclosure relates to the field of semiconductor package, and more particularly, to a method for packaging a semiconductor, a semiconductor package structure, and a package.

### BACKGROUND OF THE INVENTION

Also known as 3D or three-dimensional packaging technology, the stacked packaging technology is one of current mainstream multi-chip packaging technologies, which can stack at least two semiconductor chips (also referred to as dies, i.e., blocks having full functions diced from a wafer) along a perpendicular direction. The stacked packaging technology is generally employed to manufacture electronic components such as memory chips, logic chips, and processor chips etc. With the development of the electronics industry, high capacity, high function, high speed and small size are required for the electronic components . To meet the above requirements, it is necessary to integrate more chips into a single package, but this may increase a package height of the electronic components. Furthermore, when a semiconductor package structure moves or vibrates, there may likely be slight translocation between the chips, and this would result in poor reliability of a package structure and would have a negative effect on the performance of the package structure.

Therefore, how to reduce the package height of the package and improve the reliability of the package has become a technical problem urgently needing to be solved at present.

### SUMMARY OF THE INVENTION

A technical problem to be solved by the present disclosure is to provide a method for packaging a semiconductor, a semiconductor package structure, and a package. The present disclosure is characterized by lower package height, higher reliability, and lower warpage.

To solve the above problem, the present disclosure provides a method for packaging a semiconductor. The method includes the followings steps: providing a substrate wafer, the substrate wafer having a first surface and a second surface arranged opposite to each other, the first surface having a plurality of grooves, wherein a plurality of electrically conductive pillars are provided at a bottom of a given one of the plurality of grooves, and the plurality of electrically conductive pillars penetrate through the bottom of the given groove to the second surface; providing a plurality of semiconductor die stacks; placing the plurality of semiconductor die stacks in the grooves, wherein an upper surface of the given semiconductor die stack is lower than or flush with an upper edge of the corresponding groove, and a bottom of the given semiconductor die stack is electrically connected to the electrically conductive pillars; and covering an insulating material on the upper surface of the given semiconductor die stack to form an insulating dielectric layer, wherein the insulating dielectric layer is filled in upper parts of gaps among sidewalls of the plurality of grooves and the plurality of semiconductor die stacks to seal up the plurality of semiconductor die stacks, to thus form a semiconductor package structure.

Further, on the second surface of the substrate wafer are provided a plurality of electrically conductive blocks, and the electrically conductive blocks are electrically connected to the electrically conductive pillars.

Further, the step of forming a groove on the substrate wafer includes: planarizing the first surface of the substrate wafer; and removing a part of the substrate wafer from the first surface until the electrically conductive pillar is exposed to form the groove.

Further, the substrate wafer has a dicing lane, and the dicing lane is used as an alignment mark for forming the groove.

Further, the semiconductor die stack is formed by stacking a plurality of semiconductor dies electrically connected to each other, and electrically connected to the electrically conductive pillars through the bottom of the semiconductor die stack.

Further, the semiconductor dies are electrically connected to each other through the electrically conductive pillars penetrating through the semiconductor dies and the electrically conductive blocks between the adjacent semiconductor dies.

Further, the bottom of the semiconductor die stack is electrically connected to the electrically conductive pillars penetrating through the bottom of the groove through the electrically conductive blocks.

Further, a thermal expansion coefficient of the substrate wafer is greater than or equal to that of the insulating dielectric layer.

Further, the substrate wafer is a silicon wafer, and the insulating dielectric layer is a silicon dioxide insulating dielectric layer.

Further, the method for packaging a semiconductor further includes: covering an upper surface of the insulating dielectric layer and the first surface of the substrate wafer with a cover plate wafer.

Further, a surface of the cover plate wafer facing toward the substrate wafer has a plurality of electrically conductive pillars, and the electrically conductive pillar is electrically connected to the upper surface of the semiconductor die stack through an electrically conductive structure in the insulating dielectric layer.

Further, after the step of sealing up the semiconductor die stack, the method further includes a dicing step: dicing the semiconductor package structure along the gap between the grooves to form a plurality of mutually independent packages.

The present disclosure also provides a semiconductor package structure, which includes: a substrate wafer having a first surface and a second surface arranged opposite to each other, wherein the first surface has a plurality of grooves, a plurality of electrically conductive pillars are provided at a bottom of the groove, and the electrically conductive pillar penetrates through the bottom of the groove to the second surface; a plurality of semiconductor die stacks placed in the grooves, wherein an upper surface of the semiconductor die stack is lower than or flush with an upper edge of the groove, and a bottom of the semiconductor die stack is electrically connected to the electrically conductive pillar; and an insulating dielectric layer covering the upper surface of the semiconductor die stack, wherein the insulating dielectric layer is filled in an upper part of a gap between a sidewall of the groove and the semiconductor die stack to seal up the semiconductor die stack.

Further, on the second surface of the substrate wafer are provided a plurality of electrically conductive blocks, and the electrically conductive blocks are electrically connected to the electrically conductive pillars.

Further, the semiconductor die stack is formed by stacking a plurality of semiconductor dies electrically connected to each other, and electrically connected to the electrically conductive pillars through the bottom of the semiconductor die stack.

Further, the semiconductor dies are electrically connected to each other through the electrically conductive pillars penetrating through the semiconductor dies and the electrically conductive blocks between the adjacent semiconductor dies.

Further, the bottom of the semiconductor die stack is electrically connected to the electrically conductive pillars penetrating through the bottom of the groove through the electrically conductive blocks.

Further, a thermal expansion coefficient of the substrate wafer is greater than or equal to that of the insulating dielectric layer.

Further, the substrate wafer is a silicon wafer, and the insulating dielectric layer is a silicon dioxide insulating dielectric layer.

Further, an upper surface of the insulating dielectric layer and the first surface of the substrate wafer are covered with a cover plate wafer.

Further, a surface of the cover plate wafer facing toward the substrate wafer has a plurality of electrically conductive pillars, in the insulating dielectric layer is provided an electrically conductive structure, and the electrically conductive pillar is electrically connected to the upper surface of the semiconductor die stack through the electrically conductive structure.

The present disclosure also provides a package, which includes: a substrate having a first surface and a second surface arranged opposite to each other, wherein the first surface has at least one groove, a plurality of electrically conductive pillars are provided at a bottom of the groove, and the electrically conductive pillar penetrates through the bottom of the groove to the second surface; at least one semiconductor die stack placed in the groove, wherein an upper surface of the semiconductor die stack is lower than or flush with an upper edge of the groove, and a bottom of the semiconductor die stack is electrically connected to the electrically conductive pillar; and an insulating dielectric layer covering the upper surface of the semiconductor die stack, wherein the insulating dielectric layer is filled in an upper part of a gap between a sidewall of the groove and the semiconductor die stack to seal up the semiconductor die stack.

Advantages of the present disclosure are as below. A groove is formed on the substrate wafer to accommodate the semiconductor die stack, and an insulating dielectric layer is employed to seal up. The height of the semiconductor package structure can be greatly reduced while the same number of semiconductor dies is packaged, such that ultra-thin packaging can be achieved. In addition, the insulating dielectric layer covers the upper surface of the semiconductor die stack, and the insulating dielectric layer is filled in the upper part of the gap between the sidewall of the groove and the semiconductor die stack. While sealing up the semiconductor die stack, the insulating dielectric layer can also fix the semiconductor die stack, such that the semiconductor die stack 210 can be prevented from moving with respect to the substrate wafer 200 when the semiconductor package structure moves or vibrates. That is, the stability of the semiconductor die stack 210 is improved. Furthermore, a poor connection between the semiconductor dies 210A and a poor connection between the semiconductor die stack 210 and the substrate wafer 200 caused by the movement of the semiconductor die stack 210 can be prevented, so that the reliability of the semiconductor package structure is improved.

### BRIEF DESCRIPTION OF THE DRAWINGS

FIG. 1 is a flowchart showing steps of a method for packaging a semiconductor according to one embodiment of the present disclosure;
FIG. 2A-FIG. 2H are flowcharts illustrating the method for packaging a semiconductor according to one embodiment of the present disclosure;
FIG. 3 is a schematic diagram showing a semiconductor package structure according to one embodiment of the present disclosure; and
FIG. 4 is a schematic diagram showing the structure of a package according to one embodiment of the present disclosure.

### DETAILED DESCRIPTION OF THE EMBODIMENTS

Embodiments of a method for packaging a semiconductor, a semiconductor package structure and a package provided by the present disclosure are described below in detail with reference to the accompanying drawings.

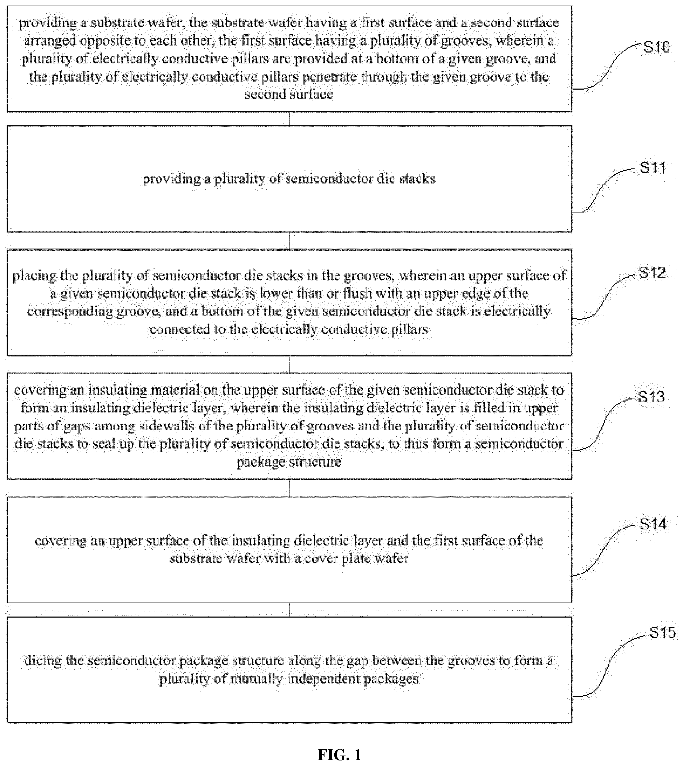

FIG. 1 is a flowchart showing steps of the method for packaging a semiconductor according to one embodiment of the present disclosure. Referring to FIG. 1, the method for packaging a semiconductor includes following steps. In Step S10, a substrate wafer is provided, and the substrate wafer has a first surface and a second surface arranged opposite to each other, wherein the first surface has a plurality of grooves, a plurality of electrically conductive pillars are provided at a bottom of the groove, and the electrically conductive pillar penetrates through the bottom of the groove to the second surface. In Step S11, a plurality of semiconductor die stacks are provided. In Step S12, the semiconductor die stack is placed in the groove, wherein an upper surface of the semiconductor die stack is lower than or flush with an upper edge of the groove, and a bottom of the semiconductor die stack is electrically connected to the electrically conductive pillar. In Step S13, an insulating material is covered on the upper surface of the semiconductor die stack to form an insulating dielectric layer, and the insulating dielectric layer is filled in an upper part of a gap between a sidewall of the groove and the semiconductor die stack to seal up the semiconductor die stack so as to form a semiconductor package structure. In Step S14, an upper surface of the insulating dielectric layer and the first surface of the substrate wafer are covered with a cover plate wafer. In Step S15, the semiconductor package structure is diced along the gap between the grooves to form a plurality of mutually independent packages.

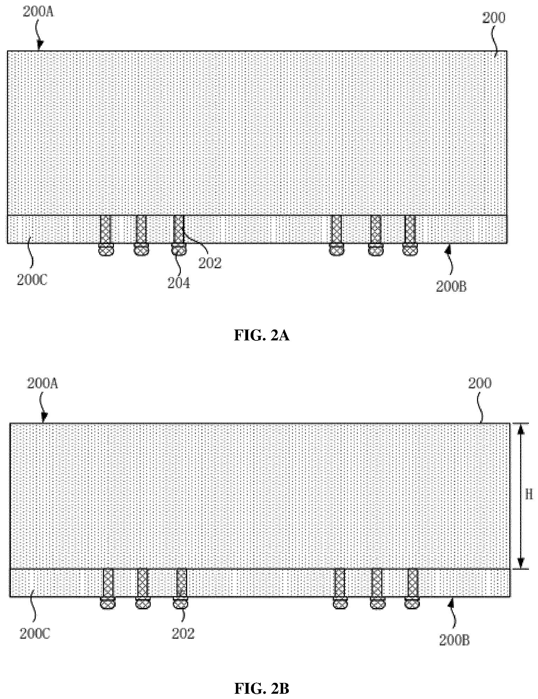

FIG. 2A-FIG. 2H are flowcharts of the method for packaging a semiconductor according to one embodiment of the present disclosure.

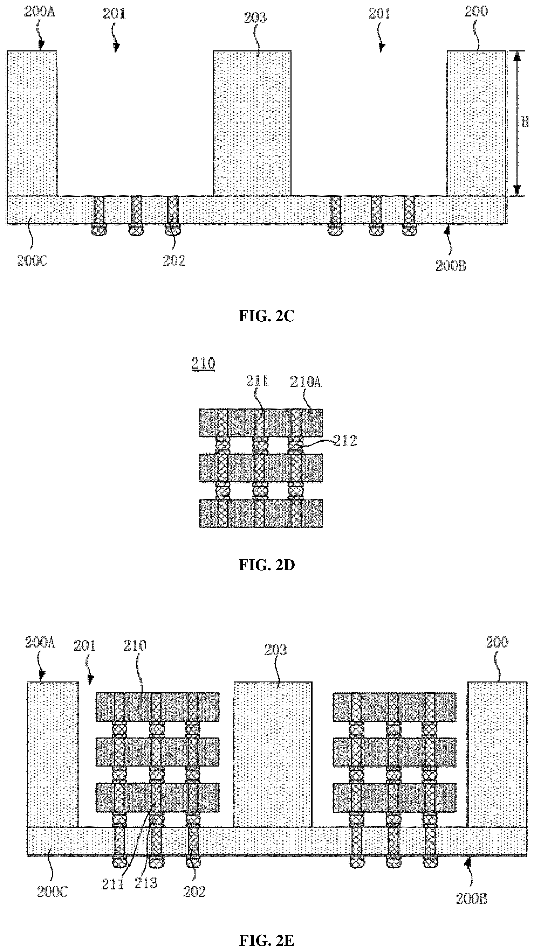

Referring to Step S10 and FIG. 2C, a substrate wafer 200 is provided, and the substrate wafer 200 has a first surface 200A and a second surface 200B arranged opposite to each other. The first surface 200A has a plurality of grooves 201, a plurality of electrically conductive pillars 202 are provided at a bottom of the groove 201, and the electrically conductive pillar 202 penetrates through the bottom of the groove 201 to the second surface 200B.

One embodiment of forming the groove 201 is described below by way of example.

Referring to FIG. 2A, the substrate wafer 200 has a first surface 200A and a second surface 200B arranged opposite to each other. The first surface 200A is a back surface of the substrate wafer 200, and the second surface 200B is a front surface of the substrate wafer 200. That is, on the second surface 200B, the substrate wafer 200 has a functional layer 200C. The electrically conductive pillar 202 extends from the second surface 200B into the substrate wafer 200, and the surface of the electrically conductive pillar 202 is exposed to the second surface 200B. The electrically conductive pillar 202 functions not only to conduct electricity, but also to conduct heat.

Referring to FIG. 2B, the first surface 200A of the substrate wafer 200 is planarized to facilitate subsequent processes. Further, the first surface 200A of the substrate wafer 200 may be planarized by using a chemical mechanical polishing method. In this step, a thickness of the substrate wafer 200 is reduced. It is to be noted that after this step is performed, a distance H from the first surface 200A of the substrate wafer 200 to the functional layer 200C of the second surface 200B should be greater than or equal to a height of the semiconductor die stack 210, so as to provide sufficient operation space for the subsequent processes, and a width of the groove 201 needs to be greater than or equal to that of the semiconductor die stack 210. Preferably, the width of the groove 201 is slightly larger than that of the semiconductor die stack 210, such that the semiconductor die stack 210 can be easily placed in the groove 201.

Referring to FIG. 2C, a part of the substrate wafer 200 is removed from the first surface 200A until the electrically conductive pillar 202 is exposed to form the groove 201. In this step, photolithography and etching processes may be employed to remove a part of the substrate wafer 200, and the etching is not stopped until the electrically conductive pillar 202 is exposed at the bottom of the groove 201. Further, when the etching is about to be stopped, etching conditions may be adjusted to ensure that the etching rate at the edge of the groove 201 is smaller than the etching rate at the middle part of the groove 201, such that a bottom corner of the groove 201 is shaped like an arc, as such shape can enhance the stability of the sidewall of the groove 201.

Further, in this step, the substrate wafer 200 has a dicing lane 203. As shown in FIG. 2C, the dicing lane 203 passes through the gap between two adjacent grooves 201 in the process of forming the grooves 201. The dicing lane 203 may be used as an alignment mark for forming the groove 201. In this way, the accuracy of forming the groove 201 is improved, and there is no need to make additional alignment marks, such that processing steps are saved, and production efficiency is improved.

The above embodiment is directed to forming the groove 201 on the first surface 200A of the substrate wafer 200. In other embodiments of the present disclosure, other methods may also be employed to form the groove 201 on the first surface 200A of the substrate wafer 200.

In this embodiment, the width of the dicing lane 203 is equal to the distance between two grooves 201. In other embodiments of the present disclosure, the groove 201 may occupy a part of space of the dicing lane 203, such that the distance between two adjacent grooves 201 is smaller than the width of the dicing lane 203, and this makes it easier to place the semiconductor die stack 210 into the groove 201 subsequently. Furthermore, a side surface of the semiconductor die stack 210 can be prevented from touching the sidewall of the groove 201 to avoid having a negative effect on the performance of the semiconductor die stack 210.

Further, with continued reference to FIG. 2A, a plurality of electrically conductive blocks 204 are provided on the second surface 200B of the substrate wafer 200, and the electrically conductive blocks 204 are electrically connected to the electrically conductive pillars 202 to electrically connect the electrically conductive pillars 202 to external devices such as printed circuit boards. The electrically conductive block 204 may be formed on the second surface 200B of the substrate wafer 200 before the groove 201 is formed.

Referring to Step S11 and FIG. 2D, a plurality of semiconductor die stacks 210 are provided. The number of the semiconductor die stacks 210 may be equal to that of the grooves 201, or the number of the semiconductor die stacks 210 may be more than that of the grooves 201. Specifically, if the number of the semiconductor die stacks 210 is equal to that of the grooves 201, in the subsequent process, one semiconductor die stack 210 is placed in one groove 201. If the number of the semiconductor die stacks 210 is more than that of the grooves 201, two or more semiconductor die stacks 210 may be placed in parallel in one groove 201.

The semiconductor die stack 210 is formed by stacking a plurality of semiconductor dies 210A. In this embodiment, three semiconductor dies 210A are schematically shown. The three semiconductor dies 210A are sequentially stacked to form the semiconductor die stack 210. In the semiconductor die stack 210, the semiconductor dies 210A are electrically connected to each other, such that an electrical signal of the semiconductor die 210A can be transmitted to an external structure. In this embodiment, the semiconductor dies 210A are electrically connected to each other through the electrically conductive pillar 211 penetrating through each of the semiconductor dies and the electrically conductive block 212 between the adjacent semiconductor dies. Each of the semiconductor dies 210A has an electrically conductive pillar 211 penetrating through the semiconductor die 210A, and the electrically conductive pillars 211 of two semiconductor dies 210A are electrically connected by the electrically conductive block 212 arranged therebetween. The method of forming the electrically conductive pillar on the semiconductor die 210A includes, but is not limited to, a through silicon via (TSV) process well known in the art.

After this step is completed, a surface of the electrically conductive pillar is exposed on the bottom of the semiconductor die stack 210, and the surface of the electrically conductive pillar is also exposed on the top of the semiconductor die stack 210.

With reference to Step S12 and FIG. 2E, the semiconductor die stack 210 is placed in the groove 201. In this step, one or more semiconductor die stacks 210 may be placed in one of the grooves 201. In this embodiment, one semiconductor die stack 210 is placed in one groove 201.

The bottom of the semiconductor die stack 210 is electrically connected to the electrically conductive pillar 202 penetrating through the bottom of the groove 201. That is, the electrically conductive pillar 211 exposed at the bottom of the semiconductor die stack 210 is electrically connected to the electrically conductive pillar 202 exposed at the bottom of the groove 201. Specifically speaking, the electrically conductive pillar 211 and the electrically conductive pillar 202 may be electrically connected through the electrically conductive block 213.

The upper surface of the semiconductor die stack 210 is lower than or flush with the upper edge of the groove 201 to facilitate subsequent processes. In this embodiment, the upper surface of the semiconductor die stack 210 is lower than the upper edge of the groove 201. In addition, to make it easier to place the semiconductor die stack 210 into the groove 201, the width of the groove 201 is greater than or equal to that of the semiconductor die stack 210. In this case, after the semiconductor die stack 210 is placed in the groove 201, there is a gap between the side surface of the semiconductor die stack 210 and the sidewall of the groove 201.

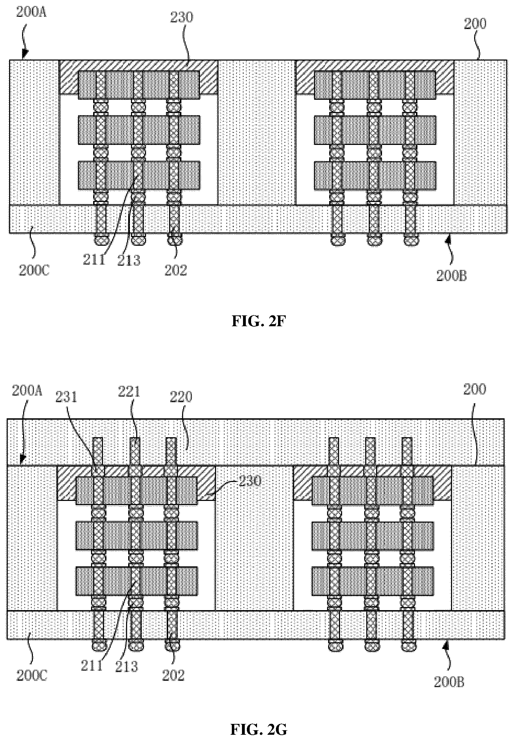

With reference to Step S13 and FIG. 2F, an insulating material is covered on the upper surface of the semiconductor die stack 210 to form an insulating dielectric layer 230, and the insulating dielectric layer 230 is filled in an upper part of a gap between a sidewall of the groove 201 and the semiconductor die stack 210 to seal up the semiconductor die stack 210. In this way, a semiconductor package structure is formed.

After this step is performed, the upper surface of the semiconductor die stack 210 and the position of the upper part of the groove 201 not occupied by the semiconductor die stack 210 are covered by the insulating dielectric layer 230, the semiconductor die stack 210 is sealed up, and the semiconductor die stack 210 is fixed with respect to the substrate wafer, such that the semiconductor die stack 210 can be prevented from moving with respect to the substrate wafer 200 when the semiconductor package structure moves or vibrates. That is, the stability of the semiconductor die stack 210 is improved. Furthermore, a poor connection between the semiconductor dies 210A and a poor connection between the semiconductor die stack 210 and the substrate wafer 200 causable by the movement of the semiconductor die stack 210 can be prevented. That is, the reliability of the semiconductor package structure is improved.

Furthermore, according to the method for packaging a semiconductor provided by the present disclosure, a groove is formed on the substrate wafer to accommodate the semiconductor die stack, and an insulating dielectric layer is employed to seal up, whereby the height of the semiconductor package structure can be greatly reduced while the same number of semiconductor dies is packaged, such that ultra-thin packaging can be achieved.

Meanwhile, the insulating dielectric layer 230 is not completely filled in the gap between the sidewall of the groove and the semiconductor die stack, as it is only filled in the upper part of the gap. In this case, when the semiconductor package structure is under heat, stratification of the insulating dielectric layer 230 from the substrate wafer 200 may not be caused by the difference between the thermal expansion coefficient of the insulating dielectric layer 230 and the thermal expansion coefficient of the substrate wafer 200.

Preferably, the thermal expansion coefficient of the substrate wafer 200 is greater than or equal to that of the insulating dielectric layer 230. The advantage thereof rests as follows. When the semiconductor package structure is under heat, the insulating dielectric layer 230 is less deformed than the substrate wafer 200 is, such that the substrate wafer 200 can be prevented from being forcedly deformed, thereby avoiding causing adverse effects on the reliability and warpage of the semiconductor package structure. Of course, the thermal expansion coefficient of the substrate wafer 200 shall not differ too much from the thermal expansion coefficient of the insulating dielectric layer 230, otherwise the insulating dielectric layer 230 may likely be detached from the sidewall of the groove 201 of the substrate wafer 200. Specifically, the substrate wafer 200 is a silicon wafer, and the insulating dielectric layer 230 is a silicon dioxide insulating dielectric layer.

Optionally, the method for packaging a semiconductor also includes following steps. With reference to Step S14 and FIG. 2G, an upper surface of the insulating dielectric layer 230 and the first surface of the substrate wafer 200 are covered with a cover plate wafer 220 to further seal up the semiconductor die stack 210. The cover plate wafer 220 and the substrate wafer 200 may be integrated by a bonding process.

Further, a surface of the cover plate wafer 220 facing toward the substrate wafer 200 has a plurality of electrically conductive pillars 221, and in the insulating dielectric layer 230 is also provided an electrically conductive pillar 231. In this case, the electrically conductive pillar 221 in the cover plate wafer 220 may be electrically connected to the upper surface of the semiconductor die stack 210 through the electrically conductive pillar 231 in the insulating dielectric layer 230. That is, the electrically conductive pillar 221 on the surface of the cover plate wafer 220 is electrically connected to the electrically conductive pillar 211 exposed on the upper surface of the semiconductor die stack 210. The cover plate wafer 220 may provide heat conduction to the semiconductor die stack 210 through the electrically conductive pillar 221, and may further fix the semiconductor die stack 210 in position. In addition, in semiconductor packaging, other wafers may be stacked on the cover plate wafer 220, and the electrically conductive pillar 221 may function as electrical connection. The step of arranging the electrically conductive pillar 231 in the insulating dielectric layer 230 may be performed before the step of covering the cover plate wafer 220.

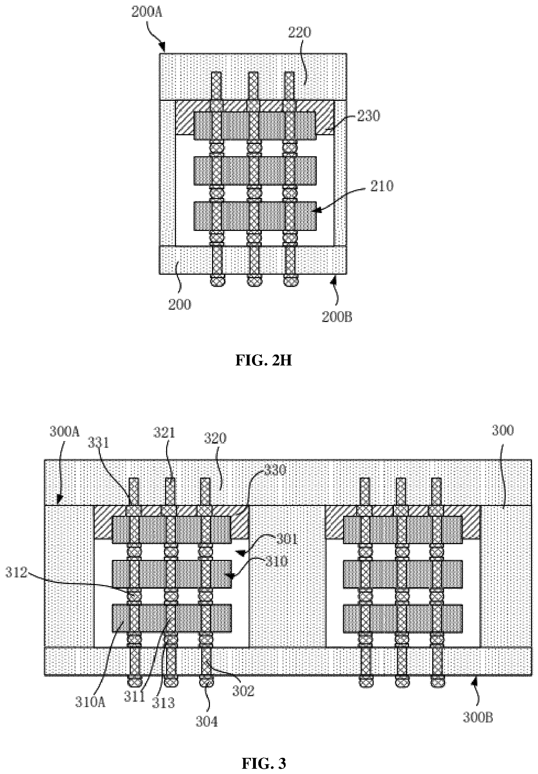

Optionally, after Step S13 or Step S14 is further included a dicing step. In this embodiment, the dicing step is further included after Step S14. With reference to Step S15 and FIG. 2H, the semiconductor package structure is diced along the gap between the grooves 201 to form a plurality of mutually independent packages. Specifically, dicing is performed along the dicing lane 203 between the grooves 201 to form a plurality of mutually independent packages. The dicing method includes, but is not limited to, mechanical dicing, laser dicing and the like.

The present disclosure also provides a semiconductor package structure formed by using the above-mentioned method for packaging a semiconductor. FIG. 3 is a schematic diagram of the semiconductor package structure according to one embodiment of the present disclosure. With reference to FIG. 3, the semiconductor package structure includes a substrate wafer 300, a plurality of semiconductor die stacks 310, an insulating dielectric layer 330, and a cover plate wafer 320.

The substrate wafer 300 has a first surface 300A and a second surface 300B arranged opposite to each other, at the first surface 300A are disposed a plurality of grooves 301, a plurality of electrically conductive pillars 302 are provided at a bottom of the groove 301, and the electrically conductive pillar 302 penetrates through the bottom of the groove 301 to the second surface 300B. At the second surface 300B of the substrate wafer 300 are provided a plurality of electrically conductive blocks 304, and the electrically conductive blocks 304 are electrically connected to the electrically conductive pillars 302.

The semiconductor die stack 310 is placed in the groove 301, and an upper surface of the semiconductor die stack 310 is lower than or flush with an upper edge of the groove 301. In this embodiment, the upper surface of the semiconductor die stack 310 is lower than the upper edge of the groove 301. A bottom of the semiconductor die stack 310 is electrically connected to the electrically conductive pillar 302. The semiconductor die stack 310 is formed by stacking a plurality of semiconductor dies 310A, the semiconductor dies 310A may be electrically connected through the electrically conductive pillar 311 penetrating through each of the semiconductor dies 310A and the electrically conductive block 312 between adjacent semiconductor dies 310A, and may be electrically connected to the electrically conductive pillar 302 penetrating through the groove 301 through the bottom of the semiconductor die stack 310. The bottom of the semiconductor die stack 310 may be electrically connected to the electrically conductive pillar 302 through the electrically conductive block 313.

The insulating dielectric layer 330 covers the upper surface of the semiconductor die stack 310, and the insulating dielectric layer 330 is filled in the upper part of the gap between the sidewall of the groove 301 and the semiconductor die stack 310 to seal up the semiconductor die stack 310. Furthermore, the plurality of semiconductor dies 310A of the semiconductor die stack 310 are fixed to each other, and the semiconductor die stack 310 is fixed with respect to the substrate wafer, such that the semiconductor die stack 310 may be prevented from moving with respect to the substrate wafer 300 when the semiconductor package structure moves or vibrates. That is, the stability of the semiconductor die stack 310 is improved, such that translocation between the semiconductor dies and between the semiconductor die stack 310 and the substrate wafer 300 may be prevented. Furthermore, a poor connection between the semiconductor dies 310A and a poor connection between the semiconductor die stack 310 and the substrate wafer 300 causable by the movement of the semiconductor die stack 310 can be prevented. In this way, the stability of the semiconductor die stack is improved, and the reliability of the semiconductor package structure is improved.

Meanwhile, the insulating dielectric layer 330 is not completely filled in the gap between the sidewall of the groove and the semiconductor die stack, but is only filled in the upper part of the gap. In this case, when the semiconductor package structure is under heat, stratification of the insulating dielectric layer 330 from the substrate wafer 300 may not be caused by the difference between the thermal expansion coefficient of the insulating dielectric layer 330 and the thermal expansion coefficient of the substrate wafer 300.

Preferably, the thermal expansion coefficient of the substrate wafer 300 is greater than or equal to that of the insulating dielectric layer 330. The advantage thereof is as follows. When the semiconductor package structure is under heat, the insulating dielectric layer 330 is less deformed than the substrate wafer 300 is, such that the substrate wafer 300 may be prevented from being forcedly deformed to avoid causing adverse effects on the reliability and warpage of the semiconductor package structure. Of course, the thermal expansion coefficient of the substrate wafer 300 shall not differ too much from the thermal expansion coefficient of the insulating dielectric layer 330, otherwise the insulating dielectric layer 330 may likely be detached from the sidewall of the groove 301 of the substrate wafer 300. Specifically speaking, the substrate wafer 300 is a silicon wafer, and the insulating dielectric layer 330 is a silicon dioxide insulating dielectric layer.

As an optional structure, the cover plate wafer 320 is covered on the insulating dielectric layer 330 and the first surface 300A of the substrate wafer 300 to seal up the semiconductor die stack 310. Further, the surface of the cover plate wafer 320 facing toward the substrate wafer 300 has a plurality of electrically conductive pillars 321, in the insulating dielectric layer 330 is also provided an electrically conductive pillar 331, and the electrically conductive pillar 321 of the cover plate wafer 320 is electrically connected to the upper surface of the semiconductor die stack 310 through the electrically conductive pillar 331 in the insulating dielectric layer 330. Specifically speaking, the electrically conductive pillar 321 is electrically connected to the electrically conductive pillar 311 exposed on the upper surface of the semiconductor die stack 310. The cover plate wafer 300 can provide heat conduction to the semiconductor die stack 310 through the electrically conductive pillar 321 and can further fix the semiconductor die stack 310 in position. In addition, in semiconductor packaging, other wafers may also be stacked on the cover plate wafer 300, and the electrically conductive pillar 321 may function as electrical connection.

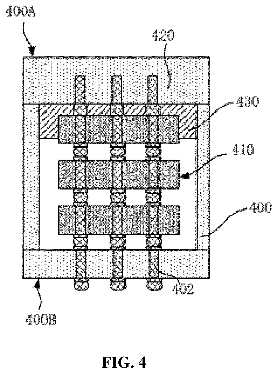

The present disclosure also provides a package formed by using the above-mentioned method for packaging a semiconductor. FIG. 4 is a schematic diagram showing the structure of the package according to one embodiment of the present disclosure. With reference to FIG. 4, the package is formed by dicing the above-mentioned semiconductor package structure along the dicing lane between the grooves. The package includes a substrate 400, at least one semiconductor die stack 410, an insulating dielectric layer 430, and a cover plate 420.

The substrate 400 has a first surface 400A and a second surface 400B arranged opposite to each other. On the first surface 400A is disposed at least one groove 401, a plurality of electrically conductive pillars 402 are provided at a bottom of the groove 401, and the electrically conductive pillar 402 penetrates through the bottom of the groove 401 to the second surface 400B.

The semiconductor die stack 410 is placed in the groove 401, an upper surface of the semiconductor die stack 410 is lower than or flush with an upper edge of the groove 401, and a bottom of the semiconductor die stack 410 is electrically connected to the electrically conductive pillar 402.

The insulating dielectric layer 430 is covered on the upper surface of the semiconductor die stack 410, the insulating dielectric layer 410 is filled in an upper part of a gap between a sidewall of the groove 401 and the semiconductor die stack 410 to seal up the semiconductor die stack 410.

As an optional structure, the cover plate 420 is covered on the upper surface of the insulating dielectric layer 430 and the first surface 400A of the substrate 400 to further seal up the semiconductor die stack 410.

The package of the present disclosure has a lower package height, and thus realizes ultra-thin packaging. Furthermore, translocation between the semiconductor dies and between the semiconductor die stack and the substrate would not occur when the package moves or vibrates. Thus, a poor connection between the semiconductor dies and a poor connection between the semiconductor die stack and the substrate wafer can be prevented. In this way, the stability of the semiconductor die stack is improved, and the reliability of the package is improved.

The above description is merely directed to preferred embodiments of the present invention. As should be pointed out, persons ordinarily skilled in the art may further make improvements and modifications without departing from the conception of the present invention, and all these improvements and modifications shall all be regarded to fall within the protection scope of the present invention.

## Claims

1. A method for packaging a semiconductor, **characterized in** comprising the following steps:
providing a substrate wafer, the substrate wafer having a first surface and a second surface arranged opposite to each other, the first surface having a plurality of grooves, wherein a plurality of electrically conductive pillars are provided at a bottom of a given one of the plurality of grooves, and the plurality of electrically conductive pillars penetrate through the bottom of the given groove to the second surface;
providing a plurality of semiconductor die stacks;
placing the plurality of semiconductor die stacks in the grooves, wherein an upper surface of the given semiconductor die stack is lower than or flush with an upper edge of the corresponding groove, and a bottom of the given semiconductor die stack is electrically connected to the electrically conductive pillars; and
covering an insulating material on the upper surface of the given semiconductor die stack to form an insulating dielectric layer, wherein the insulating dielectric layer is filled in upper parts of gaps among sidewalls of the plurality of grooves and the plurality of semiconductor die stacks to seal up the plurality of semiconductor die stacks, to thus form a semiconductor package structure.

2. The method for packaging a semiconductor according to Claim 1, wherein on the second surface of the substrate wafer are provided a plurality of electrically conductive blocks electrically connected to the electrically conductive pillars.

3. The method for packaging a semiconductor according to Claim 1, wherein the step of forming a groove on the substrate wafer comprises:
planarizing the first surface of the substrate wafer; and
removing a part of the substrate wafer from the first surface until the electrically conductive pillar is exposed to form the groove.

4. The method for packaging a semiconductor according to Claim 3, wherein the substrate wafer has a dicing lane, and the dicing lane is used as an alignment mark for forming the groove.

5. The method for packaging a semiconductor according to Claim 1, wherein the given semiconductor die stack is formed by stacking a plurality of semiconductor dies electrically connected to each other, and the bottom of the given semiconductor die stack is electrically connected to the electrically conductive pillars through the electrically conductive blocks.

6. The method for packaging a semiconductor according to Claim 5, wherein the plurality of semiconductor dies are electrically connected to each other through the electrically conductive pillars penetrating through the semiconductor dies and the electrically conductive blocks between the adjacent semiconductor dies.

7. The method for packaging a semiconductor according to Claim 1, wherein a thermal expansion coefficient of the substrate wafer is greater than or equal to a thermal expansion coefficient of the insulating dielectric layer.

8. The method for packaging a semiconductor according to Claim 7, wherein the substrate wafer is a silicon wafer, and the insulating dielectric layer is a silicon dioxide insulating dielectric layer.

9. The method for packaging a semiconductor according to Claim 1, **characterized in** further comprising: covering an upper surface of the insulating dielectric layer and the first surface of the substrate wafer with a cover plate wafer.

10. The method for packaging a semiconductor according to Claim 9, wherein a surface of the cover plate wafer facing toward the substrate wafer has a plurality of electrically conductive pillars, and a given one of the plurality of electrically conductive pillars is electrically connected to the upper surface of the corresponding semiconductor die stack through an electrically conductive structure in the insulating dielectric layer.

11. The method for packaging a semiconductor according to Claim 1, wherein after sealing up the semiconductor die stacks, the method further comprises dicing the semiconductor package structure along the gap between the grooves to form a plurality of mutually independent packages.

12. A semiconductor package structure, **characterized in** comprising:
a substrate wafer, having a first surface and a second surface arranged opposite to each other, the first surface having a plurality of grooves, wherein a plurality of electrically conductive pillars are provided at a bottom of a given one of the plurality of grooves, and the electrically conductive pillars penetrate through the bottom of the given groove to the second surface;
a plurality of semiconductor die stacks, placed in the grooves, wherein an upper surface of the given semiconductor die stack is lower than or flush with an upper edge of the corresponding groove, and a bottom of the given semiconductor die stack is electrically connected to the electrically conductive pillars; and
an insulating dielectric layer, covering the upper surfaces of the plurality of semiconductor die stacks, the insulating dielectric layer being filled in upper parts of gaps among sidewalls of the grooves and the semiconductor die stacks to seal up the semiconductor die stacks.

13. The semiconductor package structure according to Claim 12, wherein on the second surface of the substrate wafer are provided a plurality of electrically conductive blocks electrically connected to the electrically conductive pillars.

14. The semiconductor package structure according to Claim 12, wherein the semiconductor die stack is formed by stacking a plurality of semiconductor dies electrically connected to each other, and the bottom of the given semiconductor die stack is electrically connected to the electrically conductive pillars through the electrically conductive blocks.

15. The semiconductor package structure according to Claim 14, wherein the semiconductor dies are electrically connected to each other through the electrically conductive pillars penetrating through the semiconductor dies and the electrically conductive blocks between the adjacent semiconductor dies.

16. The semiconductor package structure according to Claim 12, wherein a thermal expansion coefficient of the substrate wafer is greater than or equal to a thermal expansion coefficient of the insulating dielectric layer.

17. The semiconductor package structure according to Claim 12, wherein the substrate wafer is a silicon wafer, and the insulating dielectric layer is a silicon dioxide insulating dielectric layer.

18. The semiconductor package structure according to Claim 12, wherein an upper surface of the insulating dielectric layer and the first surface of the substrate wafer are covered with a cover plate wafer.

19. The semiconductor package structure according to Claim 18, wherein a surface of the cover plate wafer facing toward the substrate wafer has a plurality of electrically conductive pillars, an electrically conductive structure is provided in the insulating dielectric layer, and a given one of the plurality of electrically conductive pillars is electrically connected to the upper surface of the corresponding semiconductor die stack through the electrically conductive structure.

20. A package, **characterized in** comprising:
a substrate, having a first surface and a second surface arranged opposite to each other, the first surface having at least one groove, wherein a plurality of electrically conductive pillars are provided at a bottom of the groove, and the plurality of electrically conductive pillars penetrate through the bottom of the groove to the second surface;
at least one semiconductor die stack, placed in the groove, wherein an upper surface of the semiconductor die stack is lower than or flush with an upper edge of the groove, and a bottom of the semiconductor die stack is electrically connected to the electrically conductive pillars; and
an insulating dielectric layer, covering the upper surface of the semiconductor die stack, the insulating dielectric layer being filled in an upper part of a gap between a sidewall of the groove and the semiconductor die stack to seal up the semiconductor die stack.
